Europäisches Patentamt

European Patent Office

Office européen des brevets

(11) Publication number: **0 256 778**
**A2**

## (12) EUROPEAN PATENT APPLICATION

(21) Application number: 87306949.6

(22) Date of filing: 05.08.87

(51) Int. Cl.⁴: **H05K 3/46** , H05K 1/00

(30) Priority: 08.08.86 US 894420

(43) Date of publication of application:
**24.02.88 Bulletin 88/08**

(84) Designated Contracting States:
**AT BE CH DE ES FR GB GR IT LI LU NL SE**

(71) Applicant: **Krajewski, Ronald**
**16781-A Milliken**
**Irvine California 92714(US)**

Applicant: **Krajewski, Laura**
**16781-A Milliken**
**Irvine California 92714(US)**

Applicant: **Johnston, Patrick**
**16781-A Milliken**
**Irvine California 92714(US)**

(72) Inventor: **Krajewski, Ronald**
**16781-A Milliken**
**Irvine California 92714(US)**
Inventor: **Krajewski, Laura**
**16781-A Milliken**
**Irvine California 92714(US)**
Inventor: **Johnston, Patrick**
**16781-A Milliken**
**Irvine California 92714(US)**

(74) Representative: **Barlow, Roy James et al**
**J.A.KEMP & CO. 14, South Square Gray's Inn**
**London WC1R 5EU(GB)**

(54) **Multi-layer printed circuit structure.**

(57) A multi-layer PC board structure is created by successively building PC board layers of metal and insulator on a carrier. Each layer is built sucessively by building a layer of circuitry, a layer of inter-layer connectors ("vias"), and a layer of protective "caps" to allow the formation of voids and throughholes. Each layer of circuitry, vias, and caps is generally built by successive deposition of a photoresist layer, exposure of the photoresist layer under a mask, and plating of metal. Photoresist material is stripped away at appropriate process steps and replaced with a flowable polyimide insulator which may be locally tailored for a desired thermal coefficient of expansion ("TCE") and a desired rigidity. The method is adapted to create PC boards with a center-oriented thermal plane ("COTP") with connectors which extend completely through, without any hard tooling. The method is also adapted to create extended three-dimensional voids within the completed PC board, and arbitrary through-holes which extend completely through the PC board, without any hard tooling.

## MULTI-LAYER PRINTED CIRCUIT STRUCTURE

### 1. Field of the Invention

The present invention relates to the field of printed circuit boards. More specifically, and without limitation of its generality, the present invention relates to the field of multi-layer printed circuit boards built upon a conformal carrier by successive layering of metals and insulators.

### 2. Description of Related Art

Printed circuit boards ("PC boards") are a means used in the electronics industry to interconnect electrical circuit components and connectors to form a unified manufactured circuit structure. Typically, after the PC board has been constructed, circuit components are attached to the PC board to form the completed circuit. One common example use of PC boards is in the computer industry, for connecting integrated semiconductor circuitry elements and other electrical circuit components. PC boards usually have connector pads which allow them to be attached to other, off board, circuit elements.

One problem which has become evident in the art is the difficulty of connecting PC boards to off board circuit elements. Soldering PC board connector pads to contact wires or other contact elements can be expensive, time-consuming, and unreliable. There is a need in the art for a PC board connector pad which can form a connecting seal with contact wires or other contact elements, which does not require a solder joint.

One method to form a solderless connector pad is to make a connector pad which has a contact rigidity which allows it to form a tight seal with the connector wire. There are electrical requirements (good electrical contact), mechanical requirements (tailorably rigid contact pads), and chemical requirements (the pad must resist corrosion). A common solution in the art has been to glue layers of PC board structure together with adhesive to form the desired PC board structure. While this method achieves its immediate goal, it is subject to the problems that (1) it generally creates an undesired electrically insulating layer of adhesive between PC board circuit elements, and (2) it generally disallows the formation of continuous metal structures.

A desired solution would be to create three-dimensional empty structures ("voids"), either embedded in the PC board or mechanically accessable to the outside of the PC board, which could present mechanical receptors for contact wires. A common method in the art is to use punch elements and dies ("hard tooling"), or drilling, which are used to remove solid material from the PC board, after it has been constructed, to form the desired voids and through-holes. While this method achieves its immediate goal, it is subject to the problems that (1) it is very expensive when small dimension through-holes or small tolerances are required, and (2) it is unable to create arbitrary three-dimensional PC board structures and is generally limited to voids which completely penetrate ("through-holes") the PC board.

Another problem which has become evident in the art is the need to prevent PC boards from warping or failing under thermal stress. Thermal stress can occur when heat is introduced, e.g. from circuit elements attached to the PC board itself, to a structure which comprises elements or bodies with differing thermal coefficients of expansion ("TCE"). Because one element expands at a different rate from another, the PC board may warp (possibly breaking wire connectors and thus causing an open circuit) or even break. One solution in the art is to use different insulator materials in PC board structures to reduce this effect, but this method is not presently very effective, and because of its expense, is not generally cost-effective.

It is also desired to create a PC board structure which is built upon a center-oriented thermal plane ("COTP"), i.e., a central structure which can transmit heat away from the circuit elements which are attached to the PC board to a heat sink or a similar element. A central structure is desired because it can be shared by two separate planes of PC board structure. A thermally balanced COTP is desired because it will not bend under thermal stress, as noted above. The inventors are not aware of any method in the prior art which is generally capable of building a PC board structure upon a COTP in a cost-effective manner.

Another problem which has become evident in the art is the need to create PC board structures which have rigidity which is tailorable at separate locations in the PC board structure. It is desired to tailor the rigidity of metal elements such as connector pads, so that the metal element can bend and hold on to a contact wire without deforming or breaking, and can form a spring-like, gas-tight metal seal. One common solution in the art is to use solder welded metal sockets to attach connector wires, a method which is subject to the drawbacks noted above.

It is also desired to tailor the rigidity of insulator elements such as the surface which embeds the connector pads, so that a durable, wearable surface can be made available to contact elements, e.g. metal contact brushes. It is also desired to be able to create flexible apendages to otherwise rigid PC boards, so that large PC board structures can be bent and conformed to constrained packaging requirements. One common solution in the art is to connect several PC board structures with cables or wires. While this method achieves its immediate goal, it can be expensive, time-consuming, and unreliable.

Accordingly, it is an object of the present invention to provide an improved PC board which has arbitrary voids created without any form of hard tooling, which has locally tailorable thermal coefficient of expansion, which may be built upon a center-oriented thermal plane and which has locally tailorable rigidity.

This and other objects of the present invention will become clear after an examination of the drawings, the description, and the claims herein.

## SUMMARY OF THE INVENTION

A multi-layer PC board structure is created by successively building PC board layers of metal and insulator on a carrier. Each layer is built sucessively by building a layer of circuitry, a layer of inter-layer connectors ("vias"), and a layer of protective "caps" to allow the formation of voids and throughholes. Each layer of circuitry, vias, and caps is generally built by successive deposition of a photoresist layer, exposure of the photoresist layer under a mask, and plating of metal. Photoresist material is stripped away at appropriate process steps and replaced with a flowable polyimide insulator which may be locally tailored for a desired thermal coefficient of expansion ("TCE") and a desired rigidity. The method is adapted to create PC boards with a center-oriented thermal plane ("COTP") with voids which extend completely through, without any hard tooling or drilling. The method is also adapted to create extended three-dimensional voids within the completed PC board, and arbitrary through-holes which extend completely through the PC board, without any hard tooling or drilling.

## BRIEF DESCRIPTION OF THE DRAWINGS

Figure 1 is a flowchart of a process embodying the present invention.

Figures 2-15 are successive cross-sections of a PC board structure which may be built with a process embodying the present invention.

Figures 16-17 are successive cross-sections of a PC board structure which may be built with a process embodying the present invention to create multiple regions with differing rigidity.

## DESCRIPTION OF THE PREFERRED EMBODIMENT

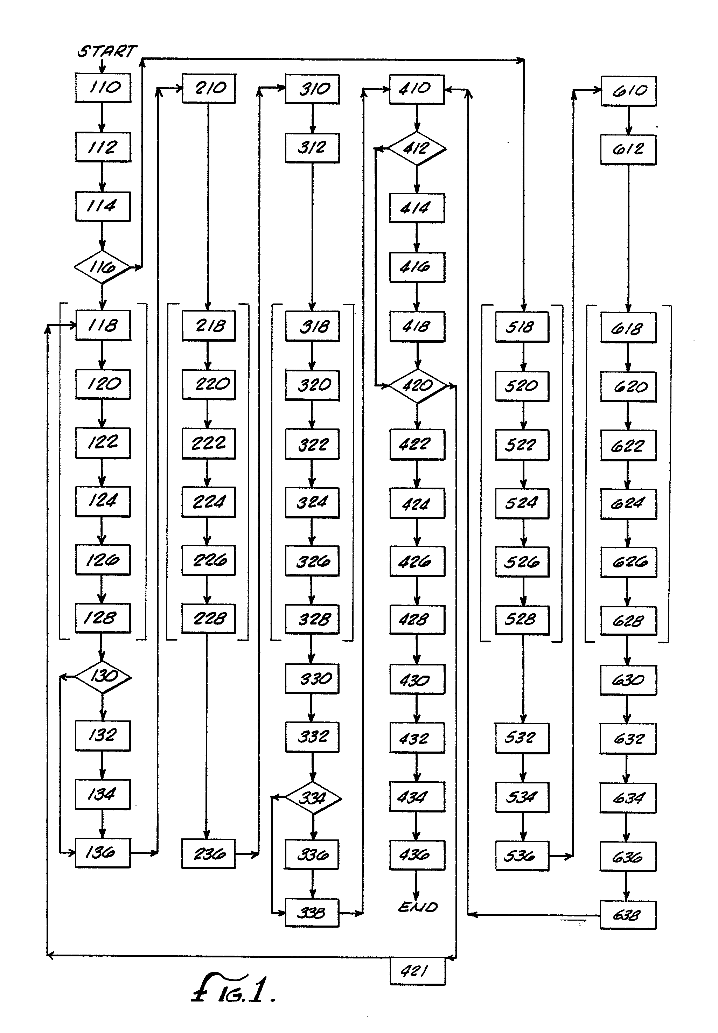

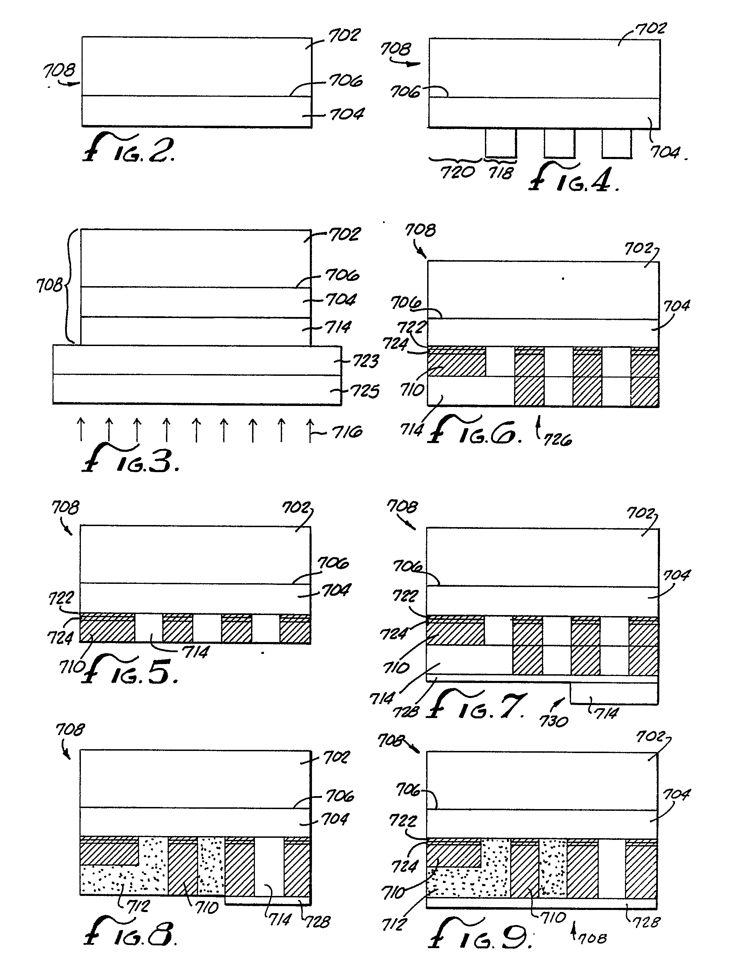

Referring generally to Figure 1, which is a flowchart of a process embodying the present invention, and to Figures 2-15, which are successive cross-sections of a PC board structure which may be built with a process embodying the present invention, a process embodying the present invention is disclosed. In a preferred embodiment, each step may be preceeded with a cleaning step, where appropriate, as is well-known in the art, to assure that residue or oxide materials from previous steps is removed, and each step may be followed with an inspection step to assure that the step was properly carried out.

The process begins at step 110, shown after the point marked "START" in Figure 1. A clean steel baseplate 702 (shown in Figure 2) provides a solid base upon which to build a multilayer printed circuit. In a preferred embodiment, the steel baseplate 702 may comprise No. 304 or No. 420 stainless steel, preferably vacuum-melted, and should be free of voids or defects in excess of about 1 mil in diameter or in excess of about 0.5 mil in depth. At step 110, the steel baseplate 702 is finished, e.g. with 400 grit sandpaper, to a roughness, as measured on a profilometer, of between about 5 microinches and about 10 microinches (RMS). Too little roughness will allow layers which are built upon the steel baseplate 702 to fail to adhere, while too much roughness will prevent such layers from being peeled away from the steel baseplate 702 at later step 428. The process continues with step 112.

At step 112, the steel baseplate 702 is pumice cleaned with a conventional circuit board cleaning pumice, and spray rinsed with deionized ("DI") water on both sides to assure that all pumice residue is removed; this is repeated until 100% wetting action on the entire surface is evidenced. The process continues with step 114.

At step 114, a conformal carrier 704 is deposited onto the steel baseplate 702 by electroplating. The conformal carrier 704 may comprise copper, but it will be clear to those of ordinary skill in the art that other metals, e.g. nickel, may generally be substituted for copper. The metal chosen must be able both to bond to the steel baseplate 702 and to be released from bonding with the steel baseplate 702 when the conformal carrier 704 is removed at later step 428. In a preferred embodiment, between about 1.5 mils and about 2.0 mils thickness is plated. Too little thickness will allow ruptures of the conformal carrier 704 by outgassing from the region of its interface with the steel baseplate 702, while too much thickness will cause the conformal carrier 704 to tend to separate from the steel · baseplate 702 because of thermal stresses during later curing steps.

The conformal carrier 704 should be stressed to make it tight against leakage between it and the steel baseplate 702, but there is generally no need to plate the entire back of the steel baseplate 702. Because plating is initiated from the front surface of the anode, and allowed to plate around to the other side, stress is normally induced as a result, also inducing a liquid-tight or gas-tight seal. In a preferred embodiment, the conformal carrier 704 should be gas tight, to prevent gas leakage, but it will usually suffice to make it liquid tight only. Liquid-tightness is required to prevent liquid baths from insinuating themselves into the interface region 706 between the steel baseplate 702 and the conformal carrier 704; if gas etchants or deposition is used, gas-tightness will of course be required. However, gas-tightness is preferred to prevent atmosphere, carrying moisture, from entering the interface region 706. A result configuration is shown in Figure 2. The process continues with step 116.

At step 116, a decision is made whether to create a PC board with a COTP. The process continues with step 118 if the decision is NO, and with step 518 if the decision is YES.

At step 118, the workpiece 708, comprising the steel baseplate 702 and the conformal carrier 704, and which may also comprise any deposited circuit metal 710 and any deposited flowable polymer 712 (as deposited in later steps) is preheated to about 150 degrees F. for a minimum of about 15 minutes, and the process continues with step 120.

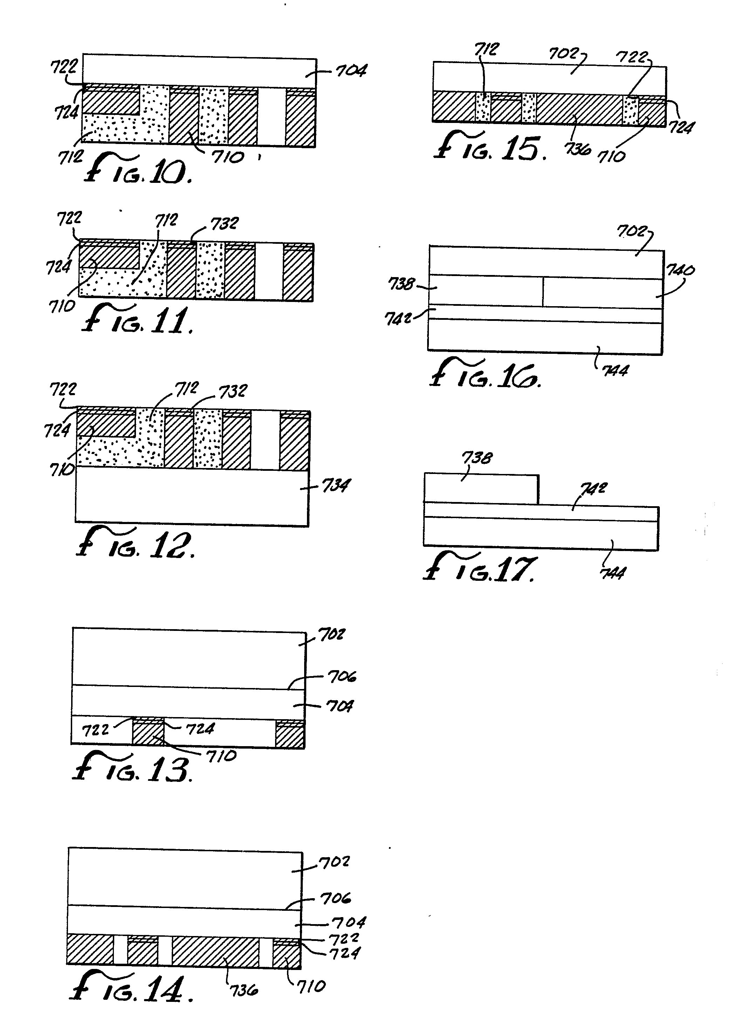

At step 120, the workpiece 708 is heated to between about 150 degrees F. and about 175 degrees F., and immediately covered with a layer of dry-film photoresist 714 (shown in Figure 3). An outside layer of protective transparent polymer covering (not shown) in which photoresist is usually packaged, is retained on the photoresist 714 to prevent its exposure to dust particles and other airborne physical hazards to the surface of the photoresist 714. Heating the workpiece 708 is preferred for at least two reasons--(1) adhesion of the photoresist 714 to the conformal carrier 704 is promoted, and (2) thermal stress of the workpiece 708, which might otherwise cause the protective transparent polymer covering to disadhere from the photoresist 714, is prevented. After application of the photoresist 714, the workpiece 708 is placed in a light-tight area and cooled to about room temperature, again to prevent thermal stress when the workpiece 708 is subjected to later room temperature process steps. The process continues with step 122.

At step 122, the photoresist 714 is exposed through a photomask, as is well-known in the art, to a light source 716 of between about 2500 watts and about 5000 watts, to result in between about 20 millijoules per square cm and about 100 millijoules per square cm of energy, of ultraviolet light with wavelength between about 300 nm and about 400 nm. Exposure creates areas of exposed photoresist 718 and areas of unexposed photoresist 720 (shown in Figure 4).

In a preferred embodiment, a photomask 723 is placed over the photoresist 714, and an very clear mylar sheet 725 is placed over the photomask. An ordinary vacuum-exposure machine, as is well-known in the art, generates a vacuum which forces the mylar and the photomask to conform to the photoresist 714 and to the workpiece 708. This prevents stray light from entering during exposure, striking the photoresist 714 where it should be masked, and causing erroneous areas of exposed photoresist 718. A typical configuration is shown in Figure 3.

It is also preferred, when drawing fine lines, e.g. 3 mils or less in width, and when creating vias, to use the thinnest commercially available photoresist 714, e.g. 0.7 mil photoresist, to assure the sharpest possible edges of exposed photoresists 718. When fine lines or vias are not being built, it may be preferred to use thicker resist, so that fewer applications will be required to obtain the desired thickness per layer, typically about 1 mil to about 2 mils. The process continues with step 124.

At step 124, the workpiece 708 is stored in a light-tight area for between about 10 minutes and about 15 minutes, (1) to allow the workpiece 708 and cooled to about room temperature, and (2) to allow cross-linking and polymerization of the photoresist 714 to achieve an optimal degree of completeness. In a preferred embodiment, the workpiece is then developed with a solvent to remove unexposed photoresist temporarily covering area 720 (i.e., negative-type photoresist 714 is used;

note that solvent photoresist 714 is preferred), and spray rinsed with DI water to clean the workpiece 708, as is well-known in the art. The process continues with step 126.

At step 126, the workpiece is plasma etched, as is well-known in the art, to remove photoresist 714 residue remaining after development, and to achieve verticality along the walls of the developed cavities of the photoresist 714. This process step is performed for all photoresist 714 layers which comprise fine line, e.g. 3 mils or less in width, and for all photoresist 714 layers which comprise vias. The plasma etching system may comprise one which is available from Dionex Corporation of San Jose, California, or any substantial equivalent.

Typical requirements for plasma etching operations, based on about 6 square feet to about 9 square feet of panel area, are (1) minimum power of about 2500 watts, (2) vacuum pressure of about 1 torr, (3) etching duration of about 6 minutes, and (4) atmospheric composition of about 85% Oxygen, 15% Freon-14. Optimum results for unique designs and for multiple loads can be arrived at quickly by trial and error, as is well-known in the art. The process continues with step 128.

At step 128, the workpiece 708 has been left with certain areas of the conformal carrier 704 which are covered by exposed photoresist 718, and with other areas of the conformal carrier 704 which are exposed to air ("exposed areas" 720). The exposed areas 720 are micro-etched by application of an ammonium persulfate solution, which may comprise 0.5 pounds of ammonium persulfate per gallon of DI water to achieve an etching rate of between about 5 microinches per minute and about 10 microinches per minute. The workpiece 708 is micro-etched for about 30 seconds, then spray-rinsed in DI water for a minimum of about 30 seconds. A typical result configuration is shown in Figure 4. The process continues with step 130.

At step 130, a decision is made whether this is the first layer of circuitry to be built. The process continues with step 132 if the decision is YES, and with step 136 if the decision is NO.

At step 132, a barrier metal 722 (shown in Figure 5) is deposited onto the exposed areas 720 by electroplating. A metal is chosen which can withstand the etching away of the conformal carrier 704 at later step 416, where it is desired to not disturb the geometry of the first circuit layers. In a preferred embodiment, the metal chosen is gold, but it will be clear to those of ordinary skill in the art that other metals, e.g. chromium, lead, nickel, silver, tin, and other metals, will serve the same purpose. For example, a different metal may be chosen to allow solderability of the pad when the conformal carrier is etched away at later step 416. In a preferred embodiment, about 30 microinches of gold 722 are plated onto the conformal carrier 704. The process continues with step 134.

At step 134, an anti-migration metal 724 is deposited onto the barrier metal 722 by electroplating. A metal is chosen which will block the atoms of the barrier metal 722 from migrating into the circuit metal 710 (which is plated at later step 136). In a preferred embodiment, the metal chosen is nickel, but it will be clear to those of ordinary skill in the art that other metals, e.g. chromium, gold, lead, silver, tin, and other metals, will serve the same purpose. In a first preferred embodiment, between about 10 microinches and about 20 microinches of nickel 724 are plated onto the barrier metal 722. In a second preferred embodiment, the thickness chosen is between about 50 microinches and about 100 microinches. This step is generally unnecessary if the barrier metal 722 does not migrate into the circuit metal 710. The process continues with step 136.

At step 136, the circuit metal 710 is deposited onto the anti-migration metal 724 by electroplating. In a preferred embodiment, the circuit metal 710 is plated to slightly beyond the top of any remaining photoresist 714. The process continues with step 210.

At step 210, the top of the photoresist 714 and the circuit metal 710 are finished to a roughness of between about 5 microinches and about 10 microinches (RMS). The circuit metal 710 and the photoresist 714 are both brought to the same level of thickness by the finishing operation. A typical result configuration is shown in Figure 5. In operation, step 210 is generally identical to step 110, but the process continues with step 218.

Steps 218, 220, 222, 224, 226, 228, and 236 collectively build vias upon the circuit which was built by steps 118, 120, 122, 124, 126, 128, 132, 134, and 136 collectively.

Step 218 is identical to step 118, but the process continues with step 220.

Step 220 is identical to step 120, but the process continues with step 222.

Step 222 is identical to step 122, but the process continues with step 224.

Step 224 is identical to step 124, but the process continues with step 226.

Step 226 is identical to step 126, but the process continues with step 228.

Step 228 is identical to step 128, but the process continues with step 236.

Step 236 is identical to step 136, but the process continues with step 310.

Step 310 is identical to step 110, but the process continues with step 312. The finishing operation of step 310 is generally necessary to allow the electroless metal in later step 312 to properly adhere. A typical result configuration, including a via 726, is shown in Figure 6.

At step 312, an electroless metal 728 is added to the photoresist 714 and the circuit metal 710. In a preferred embodiment, the metal chosen is electroless copper. Electroless deposition of metal is well-known in the art, and only a slight modification of a well-known process is used to perform the deposition. In a preferred embodiment, "Dynachem Electroless 835", available from Dynachem Corporation, is applied using the Dynachem Electroless Copper Process ("DECP"), issued 4/83, for which a specification is available from Dynachem Corporation and is hereby incorporated by reference, with the modifications noted below.

The Dynachem Epoxy Desmear Process, specification issued 4/83, which ordinarily precedes DECP, is not performed. Steps 1-2 of DECP are performed per the specification. Steps 3-6 of DECP are not performed at all. Step 7 of DECP is performed per the specification. Step 8 of DECP is modified to use a 7-9 minute duration in place of the specified 3-5 minute duration. Step 9 of DECP is performed per the specification. Steps 10-11 of DECP are not performed at all. Step 12 of DECP is modified to use a 10-14 minute duration in place of the specified 6-10 minute duration. Step 13 of DECP is modified to use a static rinse with initially DI water in place of the specified flowing water rinse. Step 14 of DECP is modified to use a shallow pan, and to use a workload minimum of 1.0 square feet of active surface per gallon of solution, with no turbulence, no bubbler, no stirring, no analysis, and no motion of the solution, in place of the specified process step. In a preferred embodiment, there is generally no need to analyse or maintain the solution, because it is appropriately discarded periodically, e.g., daily. Step 15 of DECP is modified to use a static rinse with initially DI water, in place of the specified flowing water rinse. Steps 16-22 of DECP are not performed at all, as they are unnecessary.

An additional step 23 is performed in which about 50 microinches of copper are flash electroplated, as is well-known in the art, onto the electroless copper 728 to thicken the layer of electroless copper 728. An additional step 24 is performed in which the electroless copper 728 is rinsed, as is well-known in the art. An additional step 25 is performed in which the workpiece 708 is then dried, as is well-known in the art. In a preferred embodiment, a peelable strippable vinyl, e.g. Union Carbide VP-3923, is applied to the back of the steel baseplate 702 before the electroless deposition is started, and removed after the electroless deposition is complete, to prevent electroless copper 728 from flaking off the back of the steel baseplate in later process steps.

It will be clear to one of ordinary skill in the art that other means of deposition of metal which do not require electroplating, e.g. sputtering or vacuum deposition, would adequately substitute for electroless deposition wherever small thickness coatings are desired. The process continues with step 318.

Steps 318, 320, 322, 324, 326, and 328, collectively build caps upon voids and through-holes which are being constructed. A "cap" is built upon the area which is to extend the void or through-hole which protects the electroless metal 728 from being etched away at later step 330. A typical configuration, including a cap 730, is shown in Figure 7.

The photoresist 714 is stripped, leaving electroless metal 728 protecting a photoresist 714 plug in the void or through-hole. Through-holes may be created by stripping all the photoresist 714 plugs at later step 434, while voids may be created by stripping the phorotresist 714 plugs for each layer, then leaving at least one such plug to permanently cap an internal void. It is also possible to use photo-defined solder mask to permanently cap an internal void, as is well-known in the art, or to commingle the photoresist 714 with a layer of flowable polymer 712, or to use other "tenting" methods which are known in the art.

Step 318 is identical to step 118, but the process continues with step 320.

Step 320 is identical to step 120, but the process continues with step 322.

Step 322 is identical to step 122, but the process continues with step 324.

Step 324 is identical to step 124, but the process continues with step 326.

Step 326 is identical to step 126, but the process continues with step 328.

Step 328 is identical to step 128, but the process continues with step 330.

At step 330, the electroless copper 728 is etched away, as is well-known in the art, and the process continues with step 332.

At step 332, the photoresist 714 is stripped away with a photoresist stripping agent, as is well-known in the art, and the process continues with step 334.

At step 334, a decision is made whether this is the first layer of circuitry to be built. The process continues with step 336 if the decision is YES, and with step 338 if the decision is NO.

Step 336 is identical to step 330, but the process continues with step 338.

At step 338, a flowable polymer 712 (shown in Figure 8), which may comprise a flowable polyimide, is flowed over the top of the workpiece 708 and set to a intermediate-cured solid, as is well-known in the art. Enough flowable polymer 712 is applied to cover the top of the workpiece to a level slightly beyond the top of any exposed metal (i.e., circuits, vias, and caps), and the process continues with step 410. A typical configuration is shown in Figure 8.

In a preferred embodiment, the surface onto which the flowable polymer 712 is to be flowed must first be cleaned.

If the surface to be cleaned is the conformal carrier 704 metallization, cleaning proceeds in eight steps. (1) The surface is immersed in "Dynachem LAC-4100", or any substantial equivalent, for about 2 minutes, to remove photoresist residue. (2) The surface is rinsed with flowing water for about 1 minute. (3) The surface is immersed in an ammonium persulfate bath, preferably 0.5 pounds of ammonium persulfate per gallon of DI water, for about 30 seconds, to etch oxides from the metal surface. (4) The surface is rinsed with flowing water for about 1 minute. (5) The surface is immersed in "Dynachem LC-170", or any substantial equivalent, for about 30 seconds. (6) The surface is spray rinsed with DI water for about 1 minute. (7) The surface is run through a conventional circuit board blower-dryer at about 3 feet per minute, as is well-known in the art. (8) The surface is preheated to about 150 degrees F. for a minimum of about 15 minutes prior to applying the flowable polymer 716.

If the surface to be cleaned is a previous layer of intermediate-cured polymer and metal circuits, cleaning proceeds in seven steps. (1) The surface is plasma-etched as disclosed in earlier step 126. (2) The surface is immersed in "Dynachem LAC-4100", or any substantial equivalent, for about 1 minute, to remove loose residue left by the plasma-etch operation. (3) The surface is rinsed with flowing water for about 1 minute. (4) The surface is immersed in "Dynachem LC-170", or any substantial equivalent, for about 1 minute. (5) The surface is spray rinsed with DI water for about 1 minute. (6) The surface is run through a conventional circuit board blower-dryer at about 3 feet per minute, as is well-known in the art. (7) The surface is preheated to about 150 degrees F. for a minimum of about 15 minutes prior to applying the flowable polymer 712.

In a preferred embodiment, the flowable polymer 712 may be applied by brushing on the polymer with a No. 798, 3/4 inch wide nylon brush, e.g. such as one manufactured by Low-Cornell, or any substantial equivalent, so that no loose brush strands are left after brushing. To achieve a layer of flowable polymer 712 about 2 mils to about 2.5 mils thick, the brush is dipped into the flowable polymer 712 and drawn across the surface until all the flowable polymer 712 material has been painted onto the surface; the brush is then flipped over and drawn back over the same area in reverse. This is down several times to assure that the flowable polymer 712 abuts the surface metallization and has an even thickness. The surface is then rotated 90 degrees and the brushing operation (this time without dipping in the flowable polymer 712) is repeated, perpendicular to the original brush painting operation.

The first such layer of flowable polymer 712 is placed in an oven at about 80 degrees C. for about 15 minutes to achieve a partial cure of the flowable polymer 712. The operation is then repeated with a second layer; the second layer is placed in an oven at about 80 degrees C. for about 30 minutes. Next, the workpiece is cured at about 105 degrees C. for about 30 minutes, then at about 125 degrees C. for about 30 minutes, then at about 180 degrees C. for about 30 minutes, to achieve an intermediate cure. The preceeding operation and intermediate cure is repeated for each layer of flowable polymer 712 of about 4 mils thickness.

In a preferred embodiment, the flowable polymer 712 comprises a flowable polyimide (and not a polyamide, as is typical of the prior art). The flowable polyimide may have its thermal coefficient of expansion ("TCE") altered by suitable addition of filler materials whose TCE differs from the original TCE of the flowable polyimide. Such fillers may comprise aluminum oxide, beta-eucryptite, cordierite, silica, spodumene, or other metal oxide materials.

In one filler formulation, beta-eucryptite is formed by mixing lithium carbonate, about 24.95% by weight, aluminum oxide, about 34.45% by weight, and potter's flint, about 40.60% by weight, in distilled water in clean ball mills with just enough liquid to make a flowable slip. The mixture is dried at about 110 degrees C. and pulverized to pass a 20-mesh screen before calcination. The mixture is then heated in an alumina crucible at 120 degrees C. for about 1 hour, and crushed to form particles whose size is between about 5 microns and about 10 microns in diameter.

The flowable polyimide, e.g. "duPont Pyralin" or any substantial equivalent, may have its TCE matched to various metals by addition and stirring of suitable amounts of the beta-eucryptite ("B-E") particles. Thus, to match polyimide TCE to copper TCE (about 17 ppm per degree C.), about 10.4% B-E by volume is added to the polyimide before flowing. To match polyimide TCE to alumina TCE (about 6.4 ppm per degree C.), about 47% B-E by volume is added to the polyimide before flowing. To match polyimide TCE to molybdenum TCE (about 4.9 ppm per degree C.), about 52% B-E by volume is added to the polyimide before flowing. The amount of B-E to match polyimide TCE to other materials is easily calculated.

It is possible to vary other characteristics of the flowable polyimide besides its TCE. It is possible to raise the capacitance (i.e., dielectric constant) of the polyimide by adding particles of barium titanates related members of the perovskite family of crystalline structures, or titanium dioxide. It is possible to lower the capacitance of the polyimide by adding granules of fluorocarbon polymers, e.g., polytetrafluoroethylene ("duPont Teflon"), or any substantial equivalent. It is possible to lower the resistivity of the polyimide by adding particles of carbon, ruthenium oxide, or any known conductive polymers. It is possible to raise the inductance of the polyimide by adding powdered nickel, lithium, or known magnetic ceramic particles, e.g. members of the ferrite spinel family. It would even be possible to create semiconductor effects with the polyimide by adding organic semiconductor material, if any were known.

It is possible to vary the flexibility and rigidity of the polyimide by suitable mixing of polyimides with diluting materials. Different families of polyimides have differing degrees of flexibility. In a preferred embodiment, suitable mixtures of diluting materials with the polyimides "duPont PI 2545", "duPont PI 2550", "duPont PI 2555", "duPont PI 2560", or any substantial equivalents, suffice to create a wide range of flexibility in flowable polyimides. Very flexible polyimides can be created by dilution of PI 2550 with up to about 25% n-methyl-2-pyrrolidone ("NMP"). Very rigid polyimides can be created by mixture of PI 2560 with up to about 20% PI 2545. About 5% acetone as an additive adds greatly to the effectiveness of these mixtures.

To create a PC board with multiple regions of differing flexibility, a first region of circuit metal and insulator 738 (shown in Figure 16) is built up in parallel with a copper plate 740. A second region of circuit metal and insulator 744 is then built upon the joinder layer 742. When the conformal carrier 704 is etched away, at later step 430, the copper plate 740 is also automatically removed, and a structure 746 (shown in Figure 17) results.

It is also possible to vary the flexibility and rigidity of the metallization elements by suitable layering of metals to achieve the desired flexibility or rigidity.

Step 410 is identical to step 110, but the process continues with step 412. In a preferred embodiment, a beta scope is used after this step to measure the thickness of the flowable polymer 712, to assure that the layer has a substantially uniform thickness.

At step 412, a decision is made whether this pC board is created with a COTP. The process continues with step 414 if the decision is YES, and with step 420 if the decision is NO.

At step 414, the conformal carrier 704 is removed from the steel baseplate 702 by filing the edges of the conformal carrier 704 until it is no longer mechanically stress connected to the steel baseplate 702, and mechanically peeling the conformal carrier 704 away from the steel baseplate 702. In a preferred embodiment, the edges of the steel baseplate 702 must be rounded to allow easy filing. A typical result configuration is shown in Figure 15. The process continues with step 416.

At step 416, the conformal carrier 704 is taped down and etched away to reveal the barrier metal 722 of the first circuitry layer, as is well-known in the art, and the process continues with step 418. A typical result configuration is shown in Figure 16.

Step 418 is identical to step 410, but the process continues with step 420. The finishing operation of step 418 is applied to the side of the workpiece 708 which was previously the underside of the first circuitry layer.

At step 420, a decision is made whether this is the last layer of circuitry to be built. The process continues with step 421 if the decision is NO, and with step 422 if the decision is YES.

Step 421 is identical to step 312, but the process continues with step 118. The layer of electroless metal 728 serves as a base for further photomasking and electroplating, and so the process can be repeated to generate multiple layers of circuity. A typical configuration is shown in Figure 9. When a PC board is built upon a COTP, at least one via must be raised directly from the COTP (and several are preferred) to allow the COTP to be directly connected as an electroplating anode.

At step 422, final pads 732 (shown in Figure 11) are plated (or removed, as needed) on the top of the workpiece in place of the barrier metal 722. As noted above, it may be necessary to plate metals which are receptive to solder joints, and to remove metals which are unreceptive to solder joints, before the PC board is complete. It will be clear to one of ordinary skill in the art that there is a wide selection of metals which may be suitable for final pads 732. The process continues with step 424.

At step 424, the flowable polymer 712 is final-cured, as is well-known in the art, and the process continues with step 426. In a preferred embodiment, the final-curing process may comprise heating the workpiece 708 in an oven with a non-oxidizing atmosphere at a minimum of about 300 degrees C. for a minimum of about 60 minutes.

At step 426, a stiffener element 734 (shown in Figure 12) is added if desired, as is well-known in the art, and the process continues with step 428. In a preferred embodiment, the stiffener element 734 may comprise a fiberglass board impregnated with a polyamide-imide, an epoxy resin, a bis-mal-amide, or one of the family of triazenes. The stiffener element 734 may be bonded via lamination techniques using an acrylic dry-film adhesive, as is well-known in the art. A typical result configuration is shown in Figure 12.

Step 428 is identical to step 414, but the process continues with step 430. A typical result configuration is shown in Figure 10.

Step 430 is identical to step 416, but the process continues with step 432. A typical result configuration is shown in Figure 11.

Step 432 is identical to step 422, but the process continues with step 434.

At step 434, through-hole photoresist 714 plugs are removed with a photoresist stripping agent, as is well-known in the art, and the process continues with step 436. In a preferred embodiment, the photoresist stripping agent may comprise a methylene-chloride based chemical stripping agent combined with ultrasonic agitation.

At step 436, singulation elements which were used to separate individual PC board elements when processing a single large workpiece, as is well-known in the art, are removed by etching them away, and the process ends at the point marked "END" in Figure 1.

Steps 518, 520, 522, 524, 526, 528, 532, 534, and 536 collectively build risers upon the conformal carrier 704 for later use by the COTP plate. The risers are used to connect circuitry on the side of the COTP 736 to circuitry on its other side. A typical result configuration is shown in Figure 13.

Step 518 is identical to step 118, but the process continues with step 520.

Step 520 is identical to step 120, but the process continues with step 522.

Step 522 is identical to step 122, but the process continues with step 524.

Step 524 is identical to step 124, but the process continues with step 526.

Step 526 is identical to step 126, but the process continues with step 528.

Step 528 is identical to step 128, but the process continues with step 532.

Step 532 is identical to step 132, but the process continues with step 534.

Step 534 is identical to step 134, but the process continues with step 536.

Step 536 is identical to step 136, but the process continues with step 610.

Step 610 is identical to step 310, but the process continues with step 612.

Step 612 is identical to step 312, but the process continues with step 618.

Steps 618, 620, 622, 624, 626, and 628, collectively build caps upon voids and through-holes which are being constructed, identically to steps 318, 320, 322, 324, 326, and 328, respectively.

Step 618 is identical to step 118, but the process continues with step 620.

Step 620 is identical to step 120, but the process continues with step 622.

Step 622 is identical to step 122, but the process continues with step 624.

Step 624 is identical to step 124, but the process continues with step 626.

Step 626 is identical to step 126, but the process continues with step 628.

Step 628 is identical to step 128, but the process continues with step 630.

Step 630 is identical to step 330, but the process continues with step 632.

Step 632 is identical to step 332, but the process continues with step 634.

At step 634, a tacking adhesive is applied to the conformal carrier 704, to make the COTP plate 736 (shown in Figure 14) adhere to the conformal carrier 704 when the COTP plate 736 is laid onto the conformal carrier 704 at later step 636, and the process continues with step 636.

At step 636, the COTP plate 736 is registered to align with pre-set alignment points (not shown) and laid onto the conformal carrier 704, and the process continues with step 638. In a preferred embodiment, the COTP plate 736 may have holes to match the risers which were constructed in earlier steps 518, 520, 522, 524, 526, 528, 532, 534, and 536; these holes may be drilled, etched, lasered, or constructed by another method known in the art. The COTP plate 736 must be pre-flash electroplated with an intermediate metal if the COTP plate 736 and the conformal carrier 704 have the same exposed metal. Thus, if the conformal carrier 704 comprises copper and the COTP plate 736 comprises copper-clad molybdenum, the COTP plate 736 must be pre-flash electroplated with another metal, e.g. nickel, before step 636 is performed. A typical configuration is shown in Figure 14.

Step 638 is identical to step 338, and the process continues with step 410.

While a presently preferred embodiment has been disclosed, many variations are possible which remain within the scope of the present invention.

For example, the conformal carrier 710 may be replaced with a prefabricated circuit, and the multilayer PC board structure built upon a prefabricated circuit. In general, it would be preferred to deposit a layer of electroless metal 717 before attempting to build vias, so that the entire surface of the circuit metal would achieve the same electrical potential.

For example, addition of the final layer of flowable polymer 716 may be omitted, to allow creation of a PC board with exposed circuits or contact points with very close spacing.

## Claims

1. A printed circuit board, comprising:
connector pad means for forming a contact with a connector element, which is substantially electrically and mechanically connective, and which is created without hard tooling operations.

2. A printed circuit board, comprising:
connector pad means for forming a contact with a connector element, which is substantially electrically and mechanically connective, and which is created by successive deposition of layered materials.

3. A printed circuit board, comprising:
a void of substantially predetermined shape and size, created without hard tooling operations.

4. A printed circuit board, comprising:
a void of substantially predetermined shape and size, created by successive deposition of layered materials.

5. A printed circuit board as claimed in claim 3 or 4, wherein said void is accessible to an external probe on a side of said printed circuit board.

6. A printed circuit board, comprising:
a region, including circuit metal and insulator, with a substantially predetermined and substantially uniform thermal coefficient of expansion.

7. A printed circuit board, comprising:
a region, including circuit metal and insulator, which is substantially insusceptible to thermal stress.

8. A printed circuit board, comprising:
(a) a center-oriented thermal plane;
(b) a circuit metal layer on a side of said center-oriented thermal plane.

9. A printed circuit board as claimed in claim 8, further comprising:
(a) a second circuit metal layer on a second side of said center-oriented thermal plane.

10. A printed circuit board, comprising:
a region, including circuit metal and insulator, with a substantially predetermined and substantially uniform rigidity.

11. A printed circuit board, comprising:
a region, including circuit metal and insulator, with a substantially predetermined and substantially uniform electrical property;
said electrical property being a member of the class consisting of capacitance, inductance, and dielectric constant, resistivity.

12. A printed circuit board, comprising:
a first region with a substantially predetermined and substantially uniform first rigidity; and
a second region with a substantially predetermined and substantially uniform second rigidity; and
said second rigidity being measurably different from said first rigidity.

f̃ᴵɢ.1.

fIG.2.

fIG.4.

fIG.3.

fIG.6.

fIG.5.

fIG.7.

fIG.8.

fIG.9.

FIG. 10.

FIG. 11.

FIG. 12.

FIG. 13.

FIG. 15.

FIG. 16.

FIG. 17.

FIG. 14.